# EUROPÄISCHE PATENTSCHRIFT

(11) **EP 0 530 656 B1**
(45) Veröffentlichungstag und Bekanntmachung des Hinweises auf die Patenterteilung: **28.02.1996**
(21) Anmeldenummer: 92114503.3
(22) Anmeldetag: 26.08.1992
(51) Int. Cl.: H05K 1/02, H05K 1/18, H01R 23/70

(54) **Gedruckte Schaltung mit oberflächen montierter Steckerleiste**
Printed circuit with surface mounted plug connector
Circuit imprimé avec un connecteur à fiches monté en surface

(30) Priorität: 05.09.1991 DE 4129514
(43) Veröffentlichungstag der Anmeldung: 10.03.1993
(73) Patentinhaber: TEMIC TELEFUNKEN microelectronic GmbH, D-74072 Heilbronn (DE)
(72) Erfinder: Seitz, Georg, Dipl.-Ing., W-8073 Kasing (DE)
(74) Vertreter: Maute, Hans-Jürgen, Dipl.-Ing.

(56) Entgegenhaltungen:
- EP-A- 0 044 247
- EP-A- 0 147 039
- WO-A-89/09534

## Beschreibung

Die Erfindung betrifft eine gedruckte Schaltung, die auf einer als Trägermaterial dienenden Folie angeordnet ist. Auf der gedruckten Schaltung ist eine Steckerleiste mit einer Vielzahl von Anschlußbeinchen in Oberflächenmontage-Technologie angeordnet, siehe z.B. EP-A-0 147 039.

In der Digitaltechnik sind Steckerleisten, die in Oberflächenmontage-Technologie auf der gedruckten Schaltung montiert werden, weit verbreitet. Die Steckerleisten bestehen aus einem Kunststoffkörper, der den Steckerteil beinhaltet, und aus dem aus einer Längsseite eine Reihe Anschlußbeinchen herausragen. Die Steckerleiste wird z. B. durch Vernieten oder Verkleben mit der gedruckten Schaltung verbunden. Die Anschlußbeinchen kommen dabei auf den aus der gedruckten Schaltung vorgesehenen Lötanschlußpunkten zum Liegen. Die Lötanschlußpunkte bestehen im allgemeinen aus einer Lötpaste, die durch Siebdruck auf die gedruckte Schaltung aufgetragen wird. Die feste Lötverbindung wird durch eine Erhitzung hergestellt. Die Lötpaste schmilzt auf und umfließt das entsprechende Anschlußbeinchen der Steckerleiste. Damit bei einer größeren Steckerleiste mit einer großen Anzahl von Anschlüssen alle Anschlußbeinchen während des Lötvorganges Kontakt zum Lötanschlußpunkt besitzen, muß die Steckerleiste während der Erhitzung auf die gedruckte Schaltung gepreßt werden. Nach dem Erkalten der Lötverbindung entstehen daher zwischen gedruckter Schaltung und Steckerleiste Spannungen, die durch die Verformung der Anschlußbeinchen beim Anpressen entstehen. Die Größe dieser Spannungen ist abhängig vom Anpreßdruck beim Verlöten, vom Abstand des Anschlußbeinchens vor dem Verlöten und vom Querschnitt des Anschlußbeinchens. Diese Technik der Oberflächenmontage für Steckerleisten läßt sich allerdings nur für Stecker anwenden, durch die keine allzu großen Ströme fließen und bei denen daher der Querschnitt der Anschlußbeinchen klein gewählt werden kann.

Bei Schaltungen aus dem Bereich der Leistungselektronik oder der KFZ-Elektronik, die einen höheren Strombedarf aufweisen, läßt sich die oben beschriebene Methode nicht in der Serienfertigung anwenden. Der Grund dafür liegt an den größeren Querschnitten der einzelnen Anschlußbeinchen. Die größeren Querschnitte der Anschlußbeinchen erfordern einen größeren Anpreßdruck beim Verlöten des Steckers damit beim Lötvorgang alle Anschlußbeinchen in ausreichendem Kontakt zu den entsprechenden Lötpunkten stehen. Nach dem Erkalten der Lötverbindung entstehen aufgrund der großen Querschnitte der Anschlußbeinchen verstärkte Spannungen zwischen den Anschlußbeinchen und der gedruckten Schaltung die zur Folge haben, daß sich u. U. die Anschlußbeinchen im Kunststoffkörper verformen oder daß sich die Leitbahnen von der Trägerfolie abheben. Außerdem kann es bereits beim Lötvorgang zu Verformungen der Steckerkontakte im Kunststoffgehäuse kommen. Daher werden bei gedruckten Schaltungen, deren elektrische Bauelemente oberflächenmontiert sind, die Steckerleisten, die hohen Stromanforderungen genügen müssen, durch einen zweiten Lötprozess in Durchstecktechnik mit der gedruckten Schaltung verbunden.

Aufgabe der Erfindung ist es daher, eine gedruckte Schaltung mit einer oberflächenmontierten Steckerleiste anzugeben, die auch für größere Ströme geeignet ist. Diese Aufgabe wird gelöst durch eine gedruckte Schaltung mit den kennzeichnenden Merkmalen des Anspruchs 1.

Eine weitere Aufgabe der Erfindung ist es, ein Verfahren anzugeben, mit dem eine Steckerleiste auf einer gedruckten Schaltung in Oberflächenmontage-Bauweise montiert werden kann. Diese Aufgabe wird durch ein Verfahren mit den kennzeichnenden Merkmalen des Anspruchs 7 gelöst. Die vorteilhafte Ausgestaltung der Erfindung ergibt sich aus den Unteransprüchen.

Die Erfindung zeichnet sich insbesondere dadurch aus, daß die Verspannungen, die durch das Aufdrücken der Steckerleiste auf die gedruckte Schaltung entstehen, zum größten Teil durch die Verformung der Trägerfolie im Bereich der Aussparung aufgefangen werden. Gleichzeitig werden Niveauunterschiede der Anschlußbeinchen ausgeglichen, so daß der beim Verlöten auf die Steckerleiste ausgeübte Anpreßdruck verringert werden kann. Als besonders vorteilhaft erweist es sich, wenn die Temperatur beim Lötvorgang so gewählt wird, daß die Verformungen der Trägerfolie, die durch die Anschlußbeinchen hervorgerufen werden, plastisch werden. Dadurch können Verspannungen zwischen gedruckter Schaltung und Steckerleiste im Bereich der Anschlußbeinchen vollständig vermieden werden.

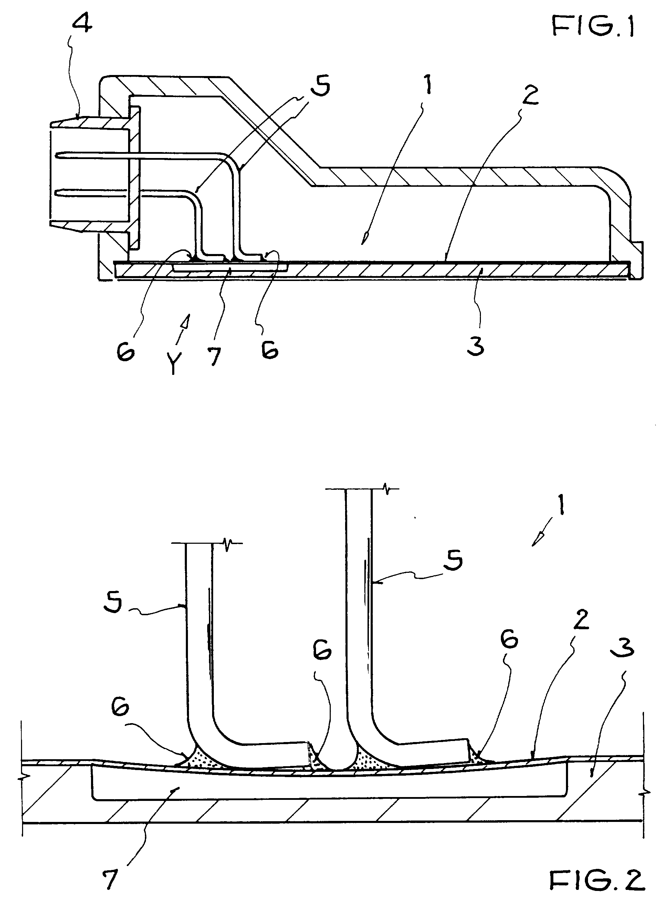

Die Erfindung wird im folgenden anhand eines Ausführungsbeispiels erläutert. Die Figur 1 zeigt einen Schnitt durch eine elektronische Baugruppe, welche eine gedruckte Schaltung 1 nach der Erfindung enthält. Die gedruckte Schaltung 1 besteht aus einer Trägerfolie 2, auf der durch übliche Verfahren Leitbahnen aufgebracht sind. Auf den Leitbahnen befindet sich eine Isolationsschicht, die die Leitbahnen bedeckt und nur an den Stellen frei gibt, an denen elektrische Bauteile mit den Leitbahnen kontaktiert werden sollen. Die Trägerfolie 2 ist auf eine Folienversteifung 3 laminiert, die der gedruckten Schaltung 1 die erwünschte mechanische Stabilität verleiht. Die Folienversteifung 3 ist im Ausführungsbeispiel vorteilhafterweise als Teil des Gehäuses 8 der elektronischen Baugruppe ausgebildet. In einer weiteren vorteilhaften Ausgestaltung der Erfindung ist die Folienversteifung 3 aus einem wärmeleitfähigen Material gefertigt. In diesem Fall übernimmt die Folienversteifung 3 zusätzlich die Funktion eines Kühlkörpers für die elektronische Baugruppe. Auf der Trägerfolie 2 sind die Bauteile der elektronischen Baugruppe durch Oberflächenmontage-Techniken zu einer Funktionsgruppe verschaltet. Zur besseren Übersicht sind diese Bauteile in der Figur 1 nicht dargestellt.

Ebenfalls in Oberflächenmontage-Technik ist auf der einen Seite der gedruckten Schaltung 1 eine Steckerleiste 4 an der gedruckten Schaltung angebracht. Die Steckerleiste 4 ist vorteilhafterweise mit der Folienversteifung 3 mechanisch verbunden, z. B. durch Nieten oder Schrauben. Weiterhin weist die Steckerleiste auf der Seite zur gedruckten Schaltung 1 eine Vielzahl von Anschlußbeinchen 5 auf, die an ihrem freien Ende parallel zur Trägerfolie 2 verlaufen und auf dieser aufliegen. An den Kontaktstellen sind die Leitbahnen der Trägerfolie frei von der Isolierschicht und mit Lötzinn versehen. Weiterhin ist im Bereich der Kontaktstellen der Anschlußbeinchen 5 zur Trägerfolie 2 eine Aussparung 7 in der Folienversteifung 3 vorgesehen. Diese Aussparung 7 ist derart angeordnet, daß die Anschlußbeinchen 5 die Trägerfolie 2 ein wenig in die Aussparung 7 drücken. Durch die unterschiedliche Verformung der Trägerfolie 2 können Niveauunterschiede der einzelnen Anschlußbeinchen 5 soweit ausgeglichen werden, daß keine Verspannungen und Verformungen der Steckerkontakte und der Anschlußbeinchen 5 auftreten und trotzdem ein ausreichender Kontakt zwischen Anschlußbeinchen 5 und Trägerfolie 2 besteht.

Figur 2 zeigt die mit y bezeichnete Einzelheit der Figur 1. Die Anschlüsse 5 der Steckerleiste verformen die Trägerfolie 2 im Bereich der Aussparung 7 derart, daß die Trägerfolie 2 über die Lötpunkte 6 in gutem Kontakt zu den Anschlüssen 5 stehen. Durch die Verformung der Trägerfolie 2 werden Verspannungen und Verformungen der Kontaktstifte in der Steckerleiste 4 abgefangen. In einer vorteilhaften Ausgestaltung der Erfindung ist die Verformung der Trägerfolie 2 durch eine Wärmebehandlung plastisch gemacht worden. Dadurch wird eine hohe Haltbarkeit der Lötverbindung 6 zwischen Anschlußbeinchen 5 der Steckerleiste 4 und den Leitbahnen auf der Trägerfolie 2 erreicht.

Zur Herstellung einer gedruckten Schaltung 1 mit einer oberflächenmontierten Steckerleiste 4 werden zunächst auf einer Trägerfolie anhand üblicher Verfahren Leitbahnen hergestellt und diese sodann mit einer Isolierung versehen. Die Kontaktstellen, an denen später Bauteile aufgelötet werden sollen, werden mit Zinn versehen. Anschließend wird die Trägerfolie 2 auf die Folienversteifung 3, die zuvor mit einer Aussparung 7 versehen wurde, auflaminiert. Die Aussparung 7 ist dabei derart angeordnet, daß die Kontaktstellen für die Steckerleistenanschlüsse über der Aussparung zum Liegen kommen. Anschließend wird auf die Kontaktstellen der Trägerfolie 2 Lötpaste, z. B. mittels Siebdruck, aufgetragen und die Bauteile vormontiert. Die Steckerleiste 4 wird zusätzlich mechanisch mit der Folienversteifung 3 vernietet oder verschraubt. Die Anschlußbeinchen 5 der Steckerleiste 4 drücken dabei auf die entsprechenden Lötpastflecken auf der Trägerfolie 2 über der Aussparung 7. Die Trägerfolie 2 kann im Bereich der Aussparung 7 dem Druck der einzelnen Anschlußbeinchen 5 nachgeben und somit Niveauunterschiede zwischen den einzelnen Anschlußbeinchen 5 durch unterschiedliche Verformung der Trägerfolie 2 ausgleichen. Anschließend wird die Anordnung in einem Temperaturschritt erhitzt, so daß die Lötpaste aufschmilzt und eine dauerhafte elektrische Verbindung zwischen den Bauteilen und den Leiterbahnen hergestellt wird. Hierbei werden in der Oberflächenmontage-Technik übliche Verfahren wie z. B. das Reflow-Verfahren eingesetzt. Die Temperatur beim Erhitzungsvorgang ist in einer vorteilhaften Ausgestaltung des erfinderischen Verfahrens so zu wählen, daß die Trägerfolie plastisch verformt bleibt. Dadurch können Verformungen und Verspannungen der Steckerleiste vermieden werden.

Durch die Erfindung ist es möglich, auch Steckerleisten mit großen Querschnitten der Anschlußbeinchen in Oberflächenmontage-Technik auf einer gedruckten Schaltung sicher zu verbinden. Ein weiterer Vorteil der Erfindung ist es, daß die Steckerleiste 4 auch dann in einem einzigen Lötprozess zusammen mit den übrigen Bauteilen in Oberflächenmontage mit der gedruckten Schaltung 1 verlötet werden kann, wenn die Art der elektronischen Baugruppe große Querschnitte der Anschlußbeinchen 5 der Steckerleiste 4 erfordert.

## Patentansprüche

1. Gedruckte Schaltung (1), die auf einer als Trägermaterial dienenden Folie (2) angeordnet ist, wobei die Trägerfolie (2) auf einer Folienversteifung (3) befestigt ist, mit einer an die gedruckte Schaltung (1) angebrachten Steckerleiste (4), die eine Vielzahl von Anschlußbeinchen (5) zur Oberflächenmontage aufweist, bei der die parallel zur Trägerfolie verlaufenden Enden der Anschlußbeinchen (5) über Lötpunkte (6) mit der gedruckten Schaltung (1) elektrisch verbunden werden, dadurch gekennzeichnet,
daß in der Folienversteifung (3) unter den Lötpunkten (6) Aussparungen (7) derart angeordnet sind, daß beim Verlöten der Anschlußbeinchen (5) mit den Lötpunkten (6) Niveauunterschiede der Anschlußbeinchen (5) durch Verformung der Trägerfolie (2) ausgeglichen werden.

2. Gedruckte Schaltung nach Anspruch 1, dadurch gekennzeichnet, daß eine einzige Aussparung (7) in der Folienversteifung (3) für sämtliche Anschlußbeinchen (5) vorgesehen ist.

3. Gedruckte Schaltung nach Anspruch 1 oder 2, dadurch gekennzeichnet, daß die Verformung der Trägerfolie (3) über den Aussparungen (7) plastisch ist.

4. Gedruckte Schaltung nach einem der Ansprüche 1 bis 3, dadurch gekennzeichnet, daß die Folienversteifung (3) einen Teil eines, die gedruckte Schaltung umgebenden Gehäuses (8) bildet.

5. Gedruckte Schaltung nach einem der Ansprüche 1 bis 4, dadurch gekennzeichnet, daß die Folienversteifung (3) aus einem wärmeleitfähigen Material besteht und als Kühlkörper dient.

6. Gedruckte Schaltung nach einem der Ansprüche 1 bis 5, dadurch gekennzeichnet, daß die Folienversteifung (3) aus Aluminium besteht.

7. Verfahren zur Herstellung einer gedruckten Schaltung nach einem der Ansprüche 1 bis 6, gekennzeichnet durch folgende Verfahrensschritte:
- Mechanisches Befestigen der Steckerleiste (4) an der gedruckten Schaltung (1), wobei die Anschlußbeinchen (5) auf den dafür vorgesehenen Lötpunkten (6) über der Aussparung (7) in der Folienversteifung (3) zum Liegen kommen,
- Montage von weiteren Bauteilen auf der gedruckten Schaltung (1),
- Herstellen der Lötverbindungen durch Erhitzen.

8. Verfahren nach Anspruch 7, dadurch gekennzeichnet, daß die Temperatur beim Herstellen der Lötverbindung so gewählt wird, daß die Verformung der Trägerfolie (2) über den Aussparungen (7) plastisch wird.

## Claims

1. A printed circuit (1) which is arranged on a foil (2) serving as carrier material, where the carrier foil (2) is fixed upon a foil reinforcement (3), with a connector strip (4) which is applied to the printed circuit (1) and which possesses a plurality of terminal pins (5) for the surface mounting, wherein those ends of the terminal pins (5) which extend in parallel to the carrier foil are electrically connected to the printed circuit (1) via soldering points (6), characterised in that in the foil reinforcement (3) below the soldering points (6) recesses (7) are arranged in such manner that during the soldering of the terminal pins (5) to the soldering points (6) differences in level of the terminal pins (5) are compensated by deformation of the carrier foil (2).

2. A printed circuit as claimed in Claim 1, characterised in that one single recess (7) is provided in the foil reinforcement (3) for all the terminal pins (5).

3. A printed circuit as claimed in Claim 1 or 2, characterised in that the deformation of the carrier foil (3) above the recesses (7) is plastic.

4. A printed circuit as claimed in one of Claims 1 to 3, characterised in that the foil reinforcement (3) forms a part of a housing (8) surrounding the printed circuit.

5. A printed circuit as claimed in one of Claims 1 to 4, characterised in that the foil reinforcement (3) consists of a thermally conductive material and serves as cooling body.

6. A printed circuit as claimed in one of Claims 1 to 5, characterised in that the foil reinforcement (3) consists of aluminium.

7. A process for the production of a printed circuit as claimed in one of Claims 1 to 6, characterised by the following process steps:
- mechanical fixing of the connector strip (5) to the printed circuit (1), where the terminal pins (5) come to lie on the soldering points (6), which latter are provided for this purpose, above the recess (7) in the foil reinforcement (3),
- mounting of further components on the printed circuit (1),
- establishment of the soldering connections by heating.

8. A process as claimed in Claim 7, characterised in that the temperature during the establishment of the soldering connection is selected such that the deformation of the carrier foil (2) above the recesses (7) becomes plastic.

## Revendications

1. Circuit imprimé (1) agencé sur une feuille (2) servant de matériau de support et fixée elle-même sur un renfort de feuille (3), avec un connecteur à enfichage (4) disposé sur le circuit imprimé (1) et présentant un grand nombre de pattes ou broches de connexion (5) pour montage en surface, les extrémités des pattes de connexion (5), extrémités qui s'étendent parallèlement à la feuille support, étant reliées électriquement au circuit imprimé (1) à travers des points de soudage (6), caractérisé en ce que
des évidements (7) sont ménagés dans le renfort de feuille (3), sous les points de soudage (6), de manière que lors du soudage des pattes de connexion (5) aux points de soudage (6), des différences de niveau des pattes (5) soient compensées par déformation de la feuille support (2).

2. Circuit imprimé selon la revendication 1, caractérisé en ce qu'un seul évidement (7) est prévu pour toutes les pattes de connexion (5) dans le renfort de feuille (3).

3. Circuit imprimé selon la revendication 1 ou 2, caractérisé en ce que la déformation de la feuille support (2) au-dessus des évidements (7) est plastique.

4. Circuit imprimé selon une des revendications 1 à 3, caractérisé en ce que le renfort de feuille (3) fait partie d'un boîtier (8) entourant le circuit imprimé.

5. Circuit imprimé selon une des revendications 1 à 4, caractérisé en ce que le renfort de feuille (3) est en matériau thermoconducteur et sert de refroidisseur.

6. Circuit imprimé selon une des revendications 1 à 5, caractérisé en ce que le renfort de feuille (3) est en aluminium.

7. Procédé pour produire un circuit imprimé selon une des revendications 1 à 6, caractérisé par les étapes de procédé suivantes:
- fixation mécanique du connecteur à enfichage (4) au circuit imprimé (1), de manière que les pattes de connexion (5) viennent s'appliquer contre les points de soudage (6) prévus pour elles au-dessus de l'évidement (7) ménagé dans le renfort de feuille (3),
- montage d'autres composants sur le circuit imprimé (1) et
- réalisation des liaisons soudées par échauffement.

8. Procédé selon la revendication 7, caractérisé en ce que la température lors de l'établissement des liaisons soudées est choisie de manière que la déformation de la feuille support (2) au-dessus des évidements (7) devienne plastique.
